# EUROPEAN PATENT APPLICATION

(11) **EP 4 851 655 A1**
(43) Date of publication of application: **09.12.2026**
(21) Application number: 25180677.4
(22) Date of filing: 04.06.2025
(51) Int. Cl.: G01R 33/48, G01R 33/561, G01R 33/54

(54) **K-SPACE ORDERING FOR A MAGNETIC RESONANCE IMAGING DATA ACQUISITION**

(71) Applicant: Siemens Healthineers AG, 91301 Forchheim (DE)
(72) Inventor: Buonincontri, Guido, 50059 Vinci (IT); Kluge, Thomas, 96114 Hirschaid (DE); Paul, Dominik, 91088 Bubenreuth (DE)
(74) Representative: Siemens Healthineers Patent Attorneys

(57) **Abstract**

In a computer-implemented method for k-space ordering for a magnetic resonance imaging, MRI, data acquisition, which comprises a sequence of echo acquisitions distributed over a plurality of data acquisition shots (17a, 17b, 17c, 17d), for each echo acquisition of the sequence, a respective parameter combination (P) of at least two acquisition parameters is received. A target combination (T) of the at least two acquisition parameters for a k-space center is received. For each echo acquisition of the sequence, a deviation measure (D) is computed, which represents a deviation of the of the respective parameter combination (P) from the target combination (T). A k-space ordering scheme (S) for carrying out the MRI data acquisition, which assigns a respective k-space segment (20) of a plurality of k-space segments (20) to be sampled to each echo acquisition of the sequence, is determined depending on the determined deviation measures (D).

## Description

The present invention relates to a computer-implemented method for k-space ordering for magnetic resonance imaging (MRI) data acquisition, which comprises a sequence of echo acquisitions distributed over a plurality of data acquisition shots, as well as to a corresponding method for controlling an MRI system. The invention is also directed to a corresponding data processing system, an MRI system comprising said data processing system, and a corresponding computer program product.

Magnetic resonance imaging is a widely used medical imaging technique that provides detailed images of internal body structures. MRI systems utilize strong magnetic fields and radio frequency (RF) pulses to generate signals from tissue, which are then processed to create images. The technique relies on the principles of nuclear magnetic resonance, where the magnetic moments of nuclei in the body are manipulated, and their responses are measured. In MRI, the spatial encoding of signals is achieved through the application of magnetic field gradients. These gradients allow the assignment of specific frequencies and phases to signals from different locations within the imaging volume. By acquiring and processing these spatially encoded signals, it is possible to reconstruct detailed cross-sectional images of the body.

In MR pulse sequences, a k-space reordering scheme or reordering index mapping function is used to assign the acquired echoes to the k-space coordinates needed for spatial encoding. In other words, for carrying out a data acquisition, a respective k-space ordering scheme is used that assigns k-space coordinates to be samples to the echo acquisitions to be carried out.

Conventional k-space reordering schemes are based on symmetries of the echo trains and assume a repetitive data acquisition sequence. For example, shifted linear ordering in 3D sequences assigns the views based on a linear time increment and shifts the views so that the k-space center is acquired at the prescribed echo time (TE). Radial ordering sorts by distance to the prescribed echo time radially and angularly.

An issue in MRI is the need to balance various acquisition parameters such as repetition time (TR), echo time, and flip angle to achieve desired image contrast while maintaining acceptable scan times. These parameters directly influence the signal intensity and contrast between different tissues. However, conventional MRI sequences typically use uniform parameter settings across the entire k-space acquisition, which may limit flexibility in optimizing contrast and efficiency.

When non-repetitive sequence patterns are used, the contrast prescription in the k-space center is not necessarily correct anymore. Furthermore, the sorted views may generate signal discontinuities in k-space, which may produce artifacts in the image.

It is an objective of the present invention to overcome said drawbacks at least in part.

This objective is achieved by the respective subject matter of the independent claims. Further implementations and preferred embodiments are subject matter of the dependent claims.

The invention is based on the idea to adaptively order k-space sampling for magnetic resonance imaging data acquisition based on deviations of two or more acquisition parameters from target parameters prescribed for the k-space center.

According to an aspect of the invention, a computer-implemented method for k-space ordering for an MRI data acquisition is provided. The MRI data acquisition comprises a sequence of echo acquisitions distributed over a plurality of data acquisition shots. The method includes receiving, for each echo acquisition of the sequence of echo acquisitions, a respective parameter combination of at least two acquisition parameters, in particular MRI acquisition parameters. A target combination of the at least two acquisition parameters for a k-space center is received. For each echo acquisition of the sequence of echo acquisitions, a deviation measure is computed, which represents a deviation of the respective parameter combination from the target combination. A k-space ordering scheme for carrying out the MRI data acquisition, which assigns a respective k-space segment of a plurality of k-space segments to be sampled to each echo acquisition of the sequence of echo acquisitions, is determined depending on the determined deviation measures.

Unless stated otherwise, all steps of the computer-implemented method may be performed by a data processing system, which comprises at least one data processing device. In particular, the at least one data processing device is configured or adapted to perform the steps of the computer-implemented method. For this purpose, the at least one data processing device may for example store a computer program comprising instructions which, when executed by the at least one data processing device, cause the at least one data processing device to execute the computer-implemented method. The expressions "data processing system" and "at least one data processing device" may be used interchangeably, here and in the following. This holds also for respective expressions derived therefrom.

In case the at least one data processing device comprises two or more data processing devices, certain steps carried out by the at least one data processing device may also be understood such that different data processing devices carry out different steps or different parts of a step. In particular, it is not required that each data processing device carries out the steps completely. In other words, carrying out the steps may be distributed amongst the two or more data processing devices.

As used herein, the term k-space segment may refer to a portion or subdivision of k-space. A k-space segment may include one or more k-space lines, where a k-space line represents a single row or column of data points in k-space, typically along the frequency encoding direction. A k-space segment may also refer to a k-space partition, which may be a single row or column of data points along the slice-select direction. k-space segments may also be 1D-curves that are not straight, such as spirals. k-space segments may also be 2D-portions or subdivisions of k-space. k-space segments may be defined based on their distance from the center of k-space, their spatial frequency content, or other criteria relevant to the imaging sequence and reconstruction method being used. The k-space segments may sometimes also be denoted as k-space indices.

The at least two acquisition parameters may, in particular, comprise or depend on at least one timing parameter for the data acquisition shots or the sequence of echo acquisitions, respectively, such as, for example echo time TE, repetition time TR, echo spacing, and/or flip angles of excitation pulses and/or refocusing pulses. In particular, a parameter of the at least two acquisition parameters may also be computed based on one or more of said individual quantities.

For example, the term echo acquisition may refer to a process of detecting and measuring magnetic resonance signals generated by excited nuclei in a sample during an MRI scan. An echo acquisition typically occurs after the application of one or more RF pulses and magnetic field gradients and may involve collecting data at a particular k-space segment of the plurality of k-space segments to be sampled. For example, the total number of echo acquisitions in the sequence of echo acquisitions may be equal to the total number of k-space segments in the plurality of k-space segments to be sampled.

For example, the term data acquisition shot may refer to a single cycle of excitation and signal acquisition in an MRI sequence. A data acquisition shot typically includes the application of one or more RF pulses, magnetic field gradients, and the subsequent collection of MRI signals. In other words, a data acquisition shot may include the application of the one or more RF pulses and magnetic field gradients and one or more echo acquisitions.

For example, the total number of echo acquisitions in the sequence of echo acquisitions may be E and the total number of data acquisition shots of the plurality of data acquisition shots may be S. Then, each data acquisition shot may be indexed by a respective shot index s with s = 1, 2, ..., S. For a given data acquisition shot, the echo acquisitions of that shot may be indexed by an echo index e with e = 1, 2, ..., Eₛ, wherein Eₛ is the number of echo acquisitions in the data acquisition shot with index s and Eₛ is equal to or greater than 1. It is possible but not required that Eₛ is the same for all data acquisition shots. In this case, Eₛ = E/S for any s.

Consequently, each echo acquisition of the sequence may be uniquely identified by a combination of a shot index s and an echo index e, in other words by a tuple (s, e). Then, the k-space ordering scheme may also be considered to assign a respective k-space segment to each tuple (s, e).

Receiving data or information may, for example, involve receiving the data or information, in particular by the data processing system from a sending entity, or reading the data or information from a data storage, and so on. In particular, wired or wireless data transmission can be used for this purpose. In particular, the data transmission may take place between a hardware and/or software interface of the sending entity and a hardware and/or software interface of the data processing system.

In particular, determining the k-space ordering scheme includes determining, for each echo acquisition of the sequence of echo acquisitions, a respective k-space segment of a plurality of k-space segments to be sampled depending on the deviation measure computed for the respective echo acquisition. This does, however, not exclude that, for a given each echo acquisition, the k-space segment assigned to it by the k-space ordering scheme may be determined depending on one or more further parameters, values or measures apart from the deviation measure.

The plurality of k-space segments to be sampled may be predefined. In particular, the plurality of k-space segments to be sampled may comprise a k-space segment corresponding to the k-space center.

The term k-space center may refer to the origin of the k-space. A k-space segment corresponding to the k-space center is, in particular, a k-space segment, which includes the k-space center.

The deviation measure represents a quantitative assessment of how much the at least two acquisition parameters for a specific echo acquisition as a whole differ from the target combination for the k-space center. In some embodiments, the deviation measure may be computed based on differences between individual acquisition parameters and their corresponding target values in the target combination. The deviation measure may be calculated using various mathematical formulations, such as Euclidean distance in a multi-dimensional parameter space, weighted sums of parameter differences, or other suitable metrics. The specific calculation method may be chosen based on the relative importance of different parameters and the desired sensitivity to parameter variations. In some cases, the deviation measure may be normalized and/or scaled to allow for more meaningful comparisons across different parameter types or ranges. This normalization may help in creating a unified metric that can be used to determine the optimal k-space ordering scheme.

The computed deviation measures may be used to inform the assignment of k-space segments to different echo acquisitions. Echo acquisitions with smaller deviation measures may be assigned to k-space segments closer to the center, for example, while those with larger deviations may be assigned to peripheral regions of k-space. This adaptive ordering approach may allow for an optimization of image contrast and quality by ensuring that the most ideal data, that is data acquired under conditions closest to the target parameters, is used to fill the most important regions of k-space.

The deviation measure considers all parameters of the at least two acquisition parameters simultaneously allowing for an overall optimization of how the k-space is sampled. In some embodiments, the at least two acquisition parameters comprise three or more parameters.

The adaptive k-space ordering approach implemented by the computer-implemented method according to the invention allows for an optimized sampling of k-space based on how closely the acquisition parameters for each echo acquisition match the desired target parameters for the k-space center. By doing so, the method can potentially improve image quality and contrast by ensuring that data most closely matching the target parameters is used to fill the central k-space region, which has the greatest impact on overall image contrast.

In particular, the k-space ordering scheme may be used as a basis for carrying out the MRI data acquisition immediately after it has been determined and/or the k-space ordering scheme may be stored for later usage. Therein, for each echo acquisition of the sequence, a respective k-space segment, which is assigned to the respective echo acquisition of the sequence according to the k-space ordering scheme, is sampled.

The k-space ordering scheme may also be used for reconstructing an MRI image based on the acquired MRI data since the k-space ordering scheme also provides a scheme for k-space reordering, that is for assign the data acquired by the individual echo acquisitions to the respective k-space segments.

According to at least one embodiment, computing the deviation measure comprises, for each acquisition parameter of the at least two acquisition parameters, computing a parameter deviation, which depends on a difference, for example an absolute value of the difference, between the value of the respective acquisition parameter for the respective echo acquisition of the sequence and the value of the respective acquisition parameter of the target combination of the at least two acquisition parameters. The deviation measure is computed depending on the computed parameter deviation.

The parameter deviation for a given acquisition parameter may be identical to the difference between the value of the respective acquisition parameter for the respective echo acquisition of the sequence and the value of the respective acquisition parameter of the target combination of the at least two acquisition parameters. Alternatively, the parameter deviation may be a function of said difference.

This approach provides a quantitative way to assess how much each echo acquisition deviates from the target parameters. By considering multiple acquisition parameters simultaneously, the method can account for complex trade-offs between different imaging parameters.

The deviation measure may be determined depending on various mathematical formulations of the differences between actual and target parameter values. For example, it may be calculated depending on ${\sum }_{i} {d}_{i}$ or depending on ${\sum }_{i} {d}_{i}^{2}$ or depending on $\sqrt{{\sum }_{i} {d}_{i}^{2} .}$

**Therein,** i is an index running over the at least two acquisition parameters and *dᵢ* is directly proportional to the difference computed for the respective acquisition parameter, which includes the examples that *dᵢ* is equal to the difference computed for the respective acquisition parameter or the absolute value of the difference computed for the respective acquisition parameter or is directly proportional to the difference computed for the respective acquisition parameter.

According to at least one embodiment, when considering a Cartesian coordinate system, wherein each axis of the coordinate system corresponds to an acquisition parameter of the at least two acquisition parameters, a first point corresponds to the target combination and a second point corresponds to the parameter combination of the respective echo acquisition of the sequence.

According to at least one embodiment, the deviation measure is computed depending on a distance between the first point and the second point.

This geometric interpretation of parameter deviations provides an intuitive way to visualize and quantify how far each echo acquisition is from the target parameters in a multi-dimensional parameter space. It allows for a unified treatment of multiple parameters and can easily accommodate additional parameters by adding dimensions to the coordinate system.

The distance between points in this parameter space may be computed using various distance metrics, such as Euclidean distance or a weighted distance measure. The choice of distance metric can be selected based on the specific requirements of the imaging application or the relative importance of different parameters.

That an axis of the coordinate system corresponds to an acquisition parameter may be understood such that coordinate values along said axis are equal to the acquisition parameters or the acquisition parameters are shifted and/or scaled to determine the respective coordinate values.

For example, the coordinate system may be defined such that the target combination or the first point, respectively, are located in the origin of the coordinate system.

According to at least one embodiment, the k-space ordering scheme is determined further depending on a direction of a vector from the first point to the second point.

By considering not just the magnitude of deviation from target parameters, but also the direction of deviation in parameter space, this approach allows for more nuanced k-space ordering. For example, it could differentiate between echo acquisitions that have the same overall deviation measure but differ in which specific parameters deviate more or less from the target combination.

This directional information may be used to assign echo acquisitions to different regions of k-space based on the nature of their parameter deviations, potentially allowing for better preservation of certain image characteristics or more efficient sampling of the full range of acquisition parameters.

The direction may for example be given by an angle the vector or a projection of the vector into one of the coordinate planes includes with a specified axis of the coordinate system. For example, in a two-dimensional coordinate system, the direction may be given by a polar angle of the vector. In a three-dimensional coordinate system, the direction may be given by a polar angle or an azimuthal angle of the vector. In higher-dimensional coordinate system, similar or analog angles may be used.

According to at least one embodiment, the plurality of k-space segments is a plurality of straight lines in k-space, which are parallel to a coordinate axis of k-space and each of the plurality of k-space segments is specified by an intersection point of the respective straight line with a k-space plane, which is perpendicular to the coordinate axis.

This approach to defining k-space segments provides a structured way to divide k-space for sampling. Using straight lines parallel to a coordinate axis simplifies the implementation and can be particularly well-suited for certain types of MRI sequences, such as Cartesian sampling schemes.

A k-space segment, which is a straight line parallel to the frequency encoding direction, is sometimes denoted k-space line, whereas a k-space segment, which is a straight line parallel to the slice-select direction, is sometimes denoted k-space partition.

According to at least one embodiment, a plurality of concentric radial regions in the k-space plane is defined, wherein the k-space center lies in a center of the plurality of concentric radial regions. A respective range for the deviation measures is specified for each radial region of the plurality of concentric radial regions. Determining the k-space ordering scheme includes determining, for each echo acquisition of the sequence, one radial region of the plurality of concentric radial regions, for which the deviation measure of the respective echo acquisition of the sequence lies in the respective range for the deviation measures, and assigning the respective echo acquisition of the sequence to a k-space segment of the plurality of k-space segments to be sampled, whose intersection point lies in the determined radial region.

This approach provides a structured way to map echo acquisitions to different regions of k-space based on their deviation from target parameters. By using concentric radial regions, it ensures that echo acquisitions with parameters closest to the target combination are assigned to the central regions of k-space, which have the greatest impact on overall image contrast and resolution.

The number and sizes of the concentric radial regions may be adjusted based on the specific imaging application and the desired trade-off between image contrast and spatial resolution. For example, more finely divided regions near the k-space center could allow for more precise control over low spatial frequency information in the reconstructed image.

Each radial region is, in particular, defined by the region between a respective inner radius, which may be zero for an innermost concentric region, and an outer radius. In particular, the concentric radial regions follow each other subsequently. In other words, except for the innermost radial region, the inner radius of a given radial region is always the outer radius of a neighboring radial region. In particular, the concentric radial regions are unique, that is they do not overlap. In particular, the plurality of concentric radial regions covers all values of the computed deviation measures.

According to at least one embodiment it is provided that, if two or more echo acquisitions of the sequence are assigned to the same radial region, the two or more echo acquisitions of the sequence are assigned to different k-space segments, whose intersection points lie in the respective radial region depending on the direction of the vector from the first point to the respective second point.

This refinement allows for more detailed assignment of echo acquisitions within each radial region. By considering the direction of deviation in parameter space, not just the magnitude, it can potentially lead to more efficient sampling of the full range of acquisition parameters and better preservation of certain image characteristics.

The specific mapping between vector direction and k-space segment assignments within a radial region could be designed to optimize various imaging goals, such as minimizing artifacts, avoiding discontinuities, maximizing contrast, and/or ensuring uniform coverage of k-space. For example, it may be provided that an increasing angle of the vector in parameter space with an axis of the parameter coordinate system may be associated with an increasing angle in k-space as well.

According to at least one embodiment, the at least two acquisition parameters comprise an echo time of the respective echo acquisition and/or a flip angle associated to the respective echo acquisition and/or a repetition time of the respective data acquisition shot and/or an inversion time of the respective data acquisition shot and/or a dead time of the respective data acquisition shot.

These acquisition parameters are particularly relevant factors that influence image contrast and signal intensity in MRI. By considering multiple parameters simultaneously, the method can account for complex interactions between different contrast mechanisms and potentially optimize image quality across a range of tissue types or pathologies.

The echo time, in particular, refers to the time between the application of an excitation pulse and the peak of the echo signal. It strongly influences the T2 contrast of the image. Shorter TEs emphasize proton density contrast, while longer TEs increase T2 weighting.

The flip angle is, for example, the angle through which the net magnetization is rotated relative to the main magnetic field direction by the application of an RF excitation pulse. It affects the balance between T1 and T2 contrast and can be used to optimize signal-to-noise ratio.

The repetition time is, for example, the time between successive excitation pulses. It primarily affects T1 contrast, with shorter repetition times increasing T1 weighting and longer repetition times reducing it.

The inversion time is, for example, used in inversion recovery sequences and refers to the time between the inversion pulse and the excitation pulse. It can be used to suppress the signal from specific tissues, such as fat or cerebrospinal fluid.

The dead time, for example, refers to periods in the sequence where no data acquisition occurs, for example due to hardware limitations or the need for magnetization recovery. Optimizing the use of this time can improve sequence efficiency.

According to at least one embodiment, the sequence of echo acquisitions is a non-repetitive sequence.

This allows for greater flexibility in sequence design and potentially more efficient sampling of k-space. Non-repetitive sequences can adapt to changing signal characteristics over the course of the acquisition, which may be particularly beneficial for certain contrast mechanisms or when imaging dynamic processes.

Non-repetitive sequences might include, for example, variable flip angle schemes, interleaved multi-echo acquisitions, or sequences with dynamically adjusted timing parameters such as the repetition time. The adaptive k-space ordering implemented by the computer-implemented method according to the invention is particularly well-suited to handle such non-repetitive sequences, as it can account for the changing acquisition parameters throughout the sequence.

According to at least one embodiment, the plurality of data acquisition shots comprises at least two subsequent data acquisition shots with different repetition times.

Variable repetition times may be used, for example, to emphasize different tissue types in different parts of k-space, to reduce specific artifacts, and/or to optimize the trade-off between contrast and acquisition time. The adaptive k-space ordering method can effectively handle these variations by considering the actual repetition time of each data acquisition shot when assigning k-space segments.

According to a further aspect of the invention, a method for controlling an MRI system is provided. The method includes carrying out the computer-implemented method for k-space ordering according to the invention, and controlling the MRI system to carry out the MRI data acquisition, in particular according to an order given by the sequence of echo acquisitions, wherein for each echo acquisition of the sequence of echo acquisitions, a respective k-space segment, which is assigned to the respective each echo acquisition of the sequence of echo acquisitions according to the k-space ordering scheme, is sampled.

This aspect of the invention integrates the adaptive k-space ordering method into the actual control of an MRI system, allowing for practical implementation of the technique. By directly linking the k-space ordering scheme to the MRI system control, it ensures that the benefits of the adaptive ordering are realized in the actual data acquisition process.

According to a further aspect of the invention, a data processing system is provided, which is configured to carry out the computer-implemented method for k-space ordering as described above.

In the present disclosure, the terms "data processing system" and "at least one data processing device" can be used interchangeably. In particular, a data processing device can be understood to mean a data processing device that contains a processing circuit. The data processing device can therefore, in particular, process data for the purpose of performing computing operations. This may also include operations for performing indexed access to a data structure, for example a look-up table, LUT, as well as a data processing method implemented in hardware.

The data processing device may include, in particular, one or more computers, one or more microcontrollers and/or one or more integrated circuits, for example one or more application-specific integrated circuits, ASIC, one or more field-programmable gate arrays, FPGA, and/or one or more systems-on-a-chip, SoC. The data processing device may also include one or more processors, for example one or more microprocessors, one or more central processing units, CPUs, one or more graphics processing units, GPUs, and/or one or more signal processors, in particular one or more digital signal processors, DSPs. The data processing device may also include a physical or virtual network of computers or other of the mentioned units.

In various embodiments, the data processing device includes one or more hardware and/or software interfaces and/or one or more storage units.

A storage unit may be a volatile data memory, for example a dynamic random access memory, DRAM, or a static random access memory, SRAM, or a non-volatile data memory, for example a read-only memory, ROM, a programmable read-only memory, PROM, an erasable programmable read-only memory, EPROM, an electrically erasable programmable read-only memory, EEPROM, a flash memory or flash EEPROM, a ferroelectric random access memory, FRAM, a magnetoresistive random access memory, MRAM, or a phase-change random access memory, PCRAM.

According to a further aspect of the invention, an MRI system is provided. The MRI system includes a data processing system according to the invention and a controller, which is configured to control the MRI system to carry out the MRI data acquisition, wherein for each echo acquisition of the sequence, a respective k-space segment, which is assigned to the respective each echo acquisition of the sequence according to the k-space ordering scheme, is sampled.

In particular, the data processing system according to the invention and the controller together carry out a method for controlling the MRI system according to the invention
According to a further aspect of the invention, a first computer program is provided. The first computer program product comprises first instructions which, when executed by a data processing system, cause the data processing system to carry out the computer-implemented method for k-space ordering according to the invention.

According to a further aspect of the invention, a second computer program is provided. The second computer program product comprises second instructions which, when executed by an MRI system according to the invention, cause the MRI system to carry out the method for controlling an MRI system according to the invention.

The first instructions and the second instructions may be provided as program code, for example. The program code can for example be provided as binary code or assembler and/or as source code of a programming language, for example C, and/or as program script, for example Python.

According to a further aspect of the invention, a computer-readable storage medium is provided, in particular a tangible and/or non-volatile computer-readable storage medium, which stores a first computer program and/or a second computer program according to the invention.

The first computer program, the second computer program and the computer-readable storage medium each are computer program products with the first instructions and/or the second instructions.

Further features of the invention are apparent from the claims, the figures and the figure description. The features and combinations of features mentioned above in the description as well as the features and combinations of features mentioned below in the description of figures and/or shown in the figures may be comprised by the invention not only in the respective combination stated, but also in other combinations. In particular, embodiments and combinations of features, which do not have all the features of an originally formulated claim, may also be comprised by the invention. Moreover, embodiments and combinations of features, which go beyond or deviate from the combinations of features set forth in the recitations of the claims may be comprised by the invention.

In the following, the invention will be explained in detail with reference to specific exemplary implementations and respective schematic drawings. In the drawings, identical or functionally identical elements may be denoted by the same reference signs. The description of identical or functionally identical elements is not necessarily repeated with respect to different figures.

In the figures,
- FIG 1: shows a schematic representation of an exemplary implementation of an MRI system according to the invention;
- FIG 2: shows schematically a flow diagram of an exemplary implementation of a computer-implemented method for k-space ordering according to the invention;
- FIG 3: shows schematically a timing diagram illustrating a sequence of data acquisition shots as a use case for a further exemplary embodiment of a computer-implemented method according to the invention;
- FIG 4: shows schematically a k-space representation with concentric circular regions used in a further exemplary embodiment of a computer-implemented method according to the invention; and
- FIG 5: shows schematically the repetition time over a plurality of data acquisition shots in a further exemplary embodiment of a computer-implemented method according to the invention.

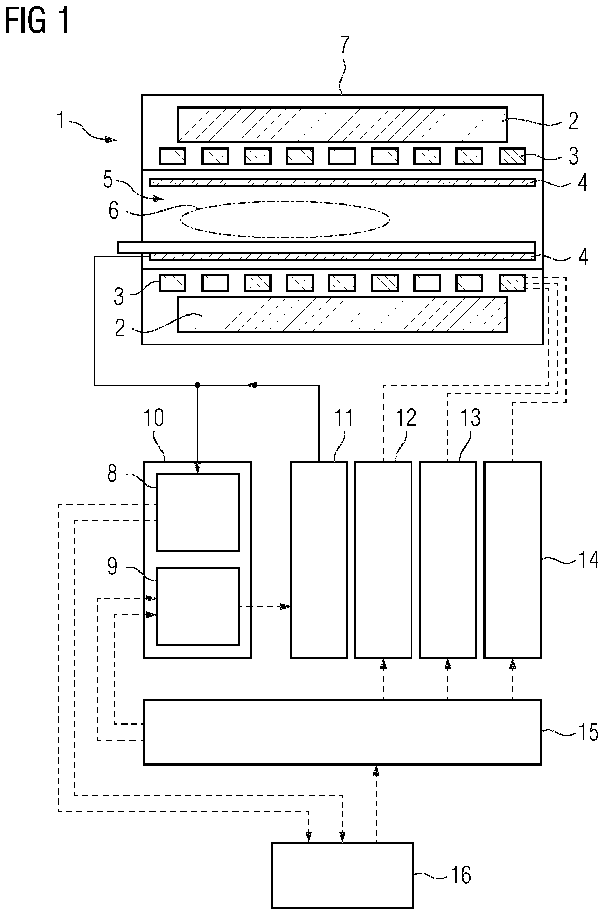

An exemplary embodiment of an MRI system 1 according to the invention is shown in FIG 1. The MRI system 1 includes a main magnet arrangement 2, a gradient coil arrangement 3, and at least one RF coil 4 arranged concentrically around a bore 5. A patient 6 can be positioned within the bore 5 for imaging. These components are, for example, housed within a magnet housing 7.

The main magnet arrangement 2 generates a strong, static magnetic field may be controlled to align the nuclear spins of the patient 6. The gradient coil arrangement 3 may be controlled produce spatially varying magnetic fields to encode spatial information into the MR signals. The at least one RF coil 4 may be controlled to transmit RF pulses to excite the nuclear spins and receives the resulting MR signals.

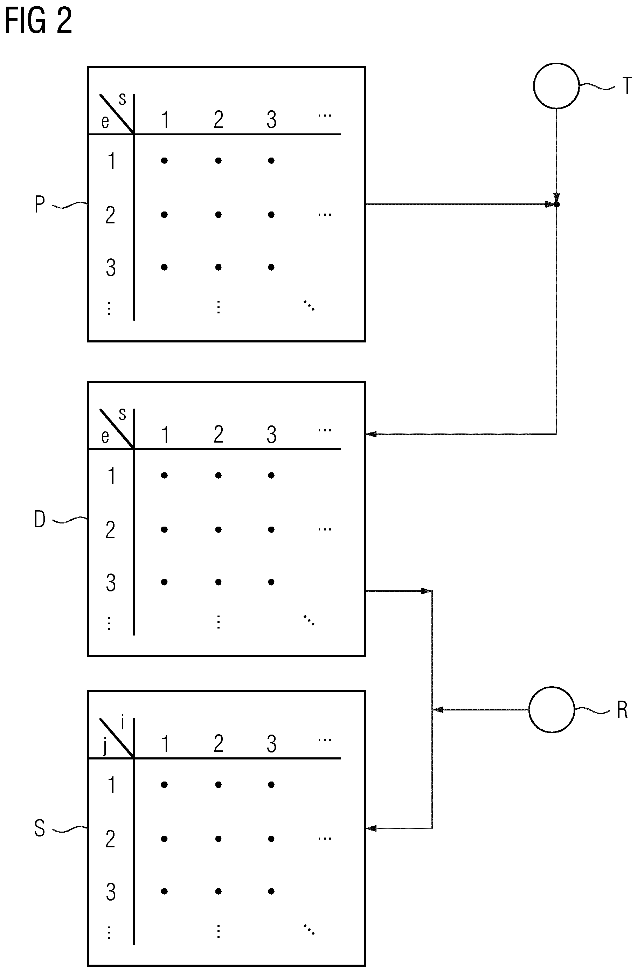

A data processing system 16 of the MRI system 1 is capable of carrying out a computer-implemented method for k-space ordering according to the invention to generate a k-space ordering scheme S (see FIG 2) for controlling the MRI system 1.

The MRI system 1 comprises an RF system 4, 10, 11 including the at least one RF coil 4, which is configured to apply RF pulses to the patient 6 and to receive MR signals emitted from the patient 6. For example, the main magnet arrangement 2 may generate a uniform main magnetic field B0 as the main magnetic field and the at least one RF coil 4 may emit an excitation field B1.

According to MR techniques, the patient 6 is subjected to the main magnetic field, causing the nuclear spins in the target material to precess about the direction of the main magnetic field at their characteristic Larmor frequency. A net magnetic moment Mz is produced in the direction z of the main magnetic field, and the randomly oriented magnetic moments of the nuclear spins cancel out one another in the x-y-plane.

When the patient 6 is then subjected to the transmit RF magnetic field, which is for example in the x-y plane and near the Larmor frequency, the net magnetic moment rotates out of the z-direction generating a net in-plane magnetic moment, whose projection rotates in the x-y plane with the Larmor frequency. In response, MR signals are emitted by the excited spins when they return to their state before the excitation. The emitted MR signals are detected, for example by the at least one RF coil 4 and/or one or more dedicated detection coils, digitized in a receiver channel 8 of an RF controller 10 of the RF system 4, 10, 11, and processed by the data processing system 16 to reconstruct an MR image using for example a known reconstruction technique.

In particular, the gradient coil arrangement 3 may produce magnetic field gradients Gx, Gy, and Gz for position-encoding of the MR signals. Accordingly, MR signals are emitted only by such nuclei of the patient 6, which correspond to the particular Larmor frequency. For example, Gz is used together with a bandwidth-limited RF pulse to select a slice perpendicular to the z-direction and consequently may also be denoted as slice selection gradient. In alternative example, Gx, Gy, and Gz may be used in any predefined combination with a bandwidth-limited RF pulse to select a slice perpendicular to the vector sum of said gradient combination. The gradient coil arrangement 3 may be supplied with current by respective amplifiers 12, 13, 14 for generating the respective gradient fields in x-direction, y-direction, and z-direction, respectively. Each amplifier 12, 13, 14 may include a respective digital-to-analog converter, which is controlled by a sequence controller 15 to generate respective gradient pulses at predefined time instances. The sequence controller 15 may control the generation of RF pulses by an emitter channel 9 of the RF controller 10 and an RF power amplifier 11 of the RF system 4, 10, 11.

The data processing system 16 may receive the real and imaginary parts from analog-digital converters of the receiver channel 8 and reconstruct the MR image based on them according to a known technique.

It is noted that the components of the MRI system 1 can also be arranged differently from the arrangement shown in FIG 1. For example, the gradient coil arrangement 3 may be arranged inside the bore 5, similar as shown for the at least one RF coil 4.

It is further noted that each component of the MRI system 1 may include other elements which are required for the operation thereof, and/or additional elements for providing functions other than those described in the present disclosure.

In particular, the data processing system 16 of the MRI system 1 carries out a computer-implemented method for k-space ordering according to the invention.

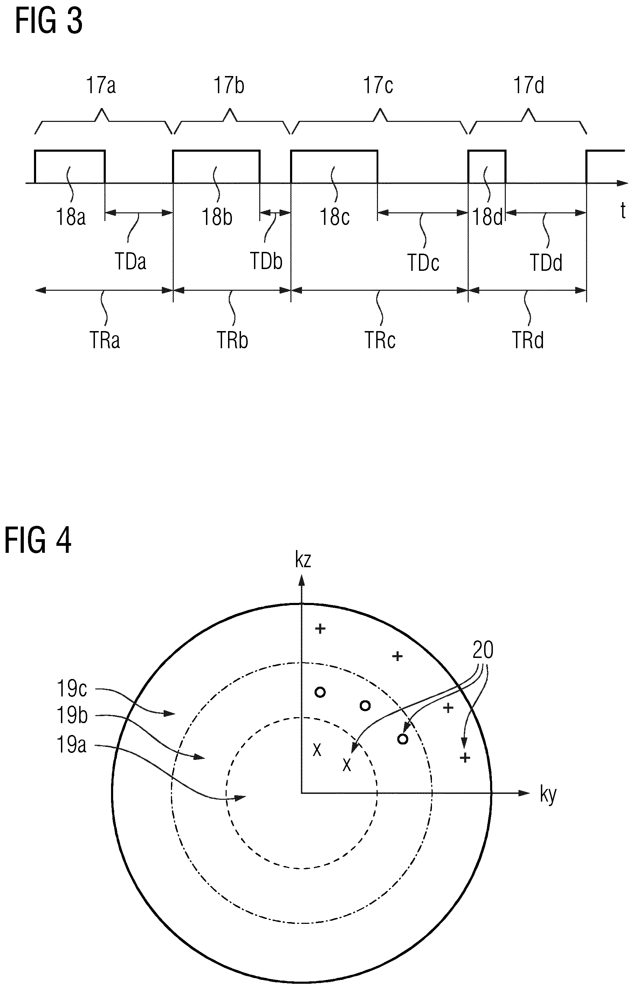

FIG 2 shows a schematic flow diagram of an exemplary implementation of a computer-implemented method according to the invention for k-space ordering for an MRI data acquisition, which comprises a sequence of echo acquisitions distributed over a plurality of data acquisition shots 17a, 17b, 17c, 17d, as schematically shown in FIG 3, for example.

For each echo acquisition of the sequence, a respective parameter combination of at least two acquisition parameters is received. In FIG 2, a table P of o parameter combinations is shown as an illustration. Therein, each echo acquisition of the sequence is identified by a tuple (s, e) corresponding to a data acquisition shot 17a, 17b, 17c, 17d with a shot index s and an echo e. Furthermore, a target combination T of the at least two acquisition parameters for the k-space center is received.

For each echo acquisition of the sequence, a deviation measure is computed, which represents a deviation of the of the respective parameter combination from the target combination T. FIG 2 shows a table D of the deviation measures for each (s, e) as an example.

A k-space ordering scheme S for carrying out the MRI data acquisition is determined depending on the determined deviation measures D. The k-space ordering scheme S assigns a respective k-space segment 20 (see FIG 4) of a plurality of k-space segments 20 to be sampled to each echo acquisition of the sequence. In the schematic illustration of FIG 2, the k-space segments 20 are by respective tuples (i, j), also denotes as k-space indices. In an example where the k-space segments 20 are k-space lines, i and j may, for example, correspond to the k-space coordinates of the k-space lines in ky- and kz- direction, respectively.

The MRI system 1 may be controlled to carry out the MRI data acquisition, wherein for each echo acquisition of the sequence, a respective k-space segment 20, which is assigned to the respective each echo acquisition of the sequence according to the k-space ordering scheme S, is sampled.

For example, the parameter combinations may correspond to a specific set of acquisition parameters such as repetition time TR and echo time TE for different k-space positions. The deviation measures D quantify differences between the parameter combinations and the target combination T. The deviation measures D may, for example, be defined as normalized distances from prescribed repetition time TR and the echo time TE values of the target combination T.

In a SPACE (Sampling Perfection with Application optimized Contrasts using different flip angle Evolution) sequence implementation, the repetition time TR may, for example, change cubically depending on the shot index s.

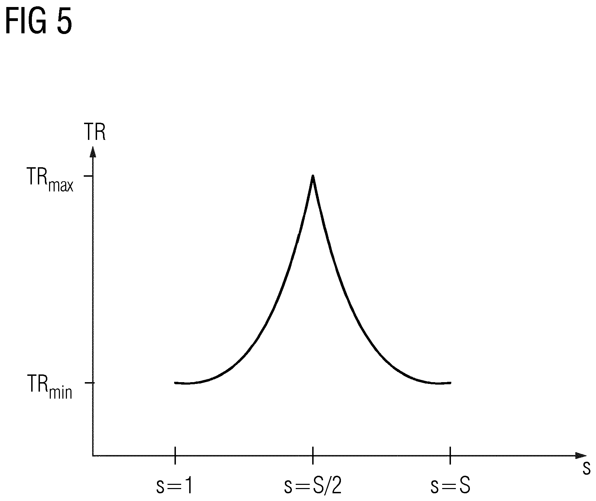

In an exemplary case, the parameter combinations consist of the repetition time TR and the echo time TE. In particular, the repetition time TR depends only on s but not on e. For example, assuming s runs from s=1 to s=S, then the repetition time TR may assume a minimum value TRₘᵢₙ at s=1 and increase, for example in a linear or polynomial, in particular, as shown in FIG 5, cubical, or exponential manner. For example, at s=S/2, the repetition time TR reaches its maximum value TRₘₐₓ and then decreases again, for example in a linear or polynomial, in particular, as shown in FIG 5, cubical or exponential manner until it reaches the minimum value TRₘᵢₙ again at s=S. The target combination T comprises, for example, TRₘₐₓ for the target repetition time and a value TE₀ for a target echo time. The echo time TE according to the parameter combinations of the sequence of echo acquisitions may vary within a given data acquisition shot and/or across the data acquisition shots. Therein, a minimum value and a maximum value of the echo time TE are given by TEₘᵢₙ and TEₘₐₓ, respectively. For example, TE₀ is neither equal to TEₘᵢₙ nor to TEₘₐₓ.

The deviation measure d(s, e) for a given echo acquisition (s, e) may then, for example, be calculated according to: $d \left(s, e\right) = \sqrt{{c}_{1}^{2} \left(s, e\right) + {c}_{2}^{2} \left(s, e\right)} ,$ ${c}_{1} \left(s, e\right) = \frac{TR - {TR}_{max}}{{TR}_{max}}$ ${c}_{2} \left(s, e\right) = \frac{TE - {TE}_{0}}{{TE}_{max} - {TE}_{0}} , if TE - {TE}_{0} > 0 ,$ ${c}_{2} \left(s, e\right) = \frac{{TE}_{0} - TE}{{TE}_{min} - {TE}_{0}} , if TE - {TE}_{0} < 0 .$

In particular, in a parameter space represented by a Cartesian coordinate systems spanned by a first axis for c₁ and a second axis for c₂, the target combination T lies in the origin and each tuple (s, e) corresponds to a parameter vector from the origin to the point (c₁(s, e), c₂(s, e)).

For example, one or more rules R (see FIG 2) may determine how to assign parameter combinations to different k-space positions based on the deviation measures D and the target combination T. The rules R may prioritize parameter combinations with smaller deviation measures D for k-space center regions, while allowing larger deviations for peripheral k-space regions.

By applying the one or more rules R, the k-space data acquisition may be adaptively reordered to optimize image quality and contrast based on the specific requirements of the MRI data acquisition. This approach allows for flexible adjustment of acquisition parameters across different regions of k-space.

FIG 3 illustrates an exemplary sequence of the data acquisition shots 17a, 17b, 17c, 17d. Each data acquisition shot 17a, 17b, 17c, 17d is associated with at least one corresponding echo train 18a, 18b, 18c, 18d. For example, the first data acquisition shot 17a includes a first echo train 18a, the second data acquisition shot 17b includes a second echo train 18b, the third data acquisition shot 17c includes a third echo train 18c, and the fourth data acquisition shot 17d includes a fourth echo train 18d.

For example, a first dead time TDa, a second dead time TDb, a third dead time TDc, and a fourth dead time TDd are intervals between the echo trains 18a, 18b, 18c, 18d of consecutive data acquisition shots 17a, 17b, 17c, 17d. The first dead time TDa follows the first data acquisition shot 17a, the second dead time TDb follows the second data acquisition shot 17b, the third dead time TDc follows the third data acquisition shot 17c, and the fourth dead time TDd follows the fourth data acquisition shot 17d.

Similarly, a first repetition time TRa, a second repetition time TRb, a third repetition time TRc, and a fourth repetition time TRd are associated with the first data acquisition shot 17a, the second data acquisition shot 17b, the third data acquisition shot 17c, and the fourth data acquisition shot 17d, respectively. These repetition times may be varied independently for different k-space regions as described above and illustrated in FIG 3 and FIG 5.

FIG 4 shows a schematic representation of a k-space with concentric radial regions 19a, 19b, 19c. For the illustration, only three radial regions 19a, 19b, 19c are shown. The k-space comprises a first radial region 19a, a second radial region 19b, and a third radial region 19c. The radial regions 19a, 19b, 19c are arranged concentrically, with the first radial region 19a being the innermost region.

For example, the plurality of k-space segments 20 is a plurality of straight lines in k-space, which are parallel to the kx-axis. Each of the plurality of k-space segments 20 is specified by an intersection point (ky, kz) of the respective straight line.

For example, a respective range for the deviation measures D is specified for each of the radial region 19a, 19b, 19c. For each echo acquisition of the sequence, a respective radial region 19a, 19b, 19c, for which the deviation measure lies in the respective range for the deviation measures D is determined, and the respective echo acquisition of the sequence is assigned to a k-space segment 20, whose intersection point lies in the determined radial region 19a, 19b, 19c.

If two or more echo acquisitions of the sequence are assigned to the same radial region 19a, 19b, 19c, the two or more echo acquisitions of the sequence are assigned to different k-space segments 20, whose intersection points lie in the respective radial region 19a, 19b, 19c, for example depending on the direction of the respective parameter vector, for example (c₁(s, e), c₂(s, e)) in the embodiment explained above. For example, the k-space segments 20 in a given radial region 19a, 19b, 19c may be sorted angularly according to an angle, the parameter vector includes with the c₁-axis or the c₂-axis.

By utilizing this k-space representation and segmentation scheme, the MRI system 1 may optimize the acquisition of k-space data for certain use cases, potentially improving image quality and contrast by adapting the acquisition parameters for different regions of k-space.

Independent of the grammatical term usage, individuals with male, female or other gender identities are included within the term.

## Claims

1. Computer-implemented method for k-space ordering for a magnetic resonance imaging, MRI, data acquisition, which comprises a sequence of echo acquisitions distributed over a plurality of data acquisition shots (17a, 17b, 17c, 17d), wherein
- for each echo acquisition of the sequence, a respective parameter combination (P) of at least two acquisition parameters is received;
- a target combination (T) of the at least two acquisition parameters for a k-space center is received;
- for each echo acquisition of the sequence, a deviation measure (D) is computed, which represents a deviation of the of the respective parameter combination (P) from the target combination (T);
- a k-space ordering scheme (S) for carrying out the MRI data acquisition, which assigns a respective k-space segment (20) of a plurality of k-space segments (20) to be sampled to each echo acquisition of the sequence, is determined depending on the determined deviation measures (D).

2. Computer-implemented method according to claim 1, wherein computing the deviation measure (D) comprises
- for each acquisition parameter of the at least two acquisition parameters, computing a parameter deviation, which depends on a difference between the value of the respective acquisition parameter for the respective echo acquisition of the sequence and the value of the respective acquisition parameter of the target combination (T) of the at least two acquisition parameters;
- and computing the deviation measure (D) depending on the computed parameter deviations.

3. Computer-implemented method according to claim 2, wherein the deviation measure (D) is determined depending on ${\sum }_{i} {d}_{i}$ or depending on ${\sum }_{i} {d}_{i}^{2}$ or depending on $\sqrt{{\sum }_{i} {d}_{i}^{2} ,}$ wherein i is an index running over the at least two acquisition parameters and *dᵢ* is directly proportional to the difference computed for the respective acquisition parameter.

4. Computer-implemented method according claim 1, wherein, when considering a Cartesian coordinate system, wherein each axis of the coordinate system corresponds to an acquisition parameter of the at least two acquisition parameters, the deviation measure (D) is computed depending on a distance between a first point corresponding to the target combination (T) and a second point corresponding to the parameter combination (P) of the respective echo acquisition of the sequence.

5. Computer-implemented method according to claim 4, wherein the k-space ordering scheme (S) is determined further depending on a direction of a vector from the first point to the second point.

6. Computer-implemented method according to one of the preceding claims, wherein the plurality of k-space segments (20) is a plurality of straight lines in k-space, which are parallel to a coordinate axis of k-space and each of the plurality of k-space segments (20) is specified by an intersection point of the respective straight line with a k-space plane, which is perpendicular to the coordinate axis.

7. Computer-implemented method according to claim 6, wherein
- a plurality of concentric radial regions (19a, 19b, 19c) in the k-space plane is defined, wherein the k-space center lies in a center of the plurality concentric radial regions (19a, 19b, 19c);
- a respective range for the deviation measures (D) is specified for each radial region (19a, 19b, 19c) of the plurality of concentric radial regions (19a, 19b, 19c); and
- determining the k-space ordering scheme (S) includes determining for each echo acquisition of the sequence one radial region (19a, 19b, 19c) of the plurality of concentric radial regions (19a, 19b, 19c), for which the deviation measure (D) of the respective echo acquisition of the sequence lies in the respective range for the deviation measures (D), and assigning the respective echo acquisition of the sequence to a k-space segment (20), whose intersection point lies in the determined radial region (19a, 19b, 19c).

8. Computer-implemented method according to claim 7 and claim 5, wherein, if two or more echo acquisitions of the sequence are assigned to the same radial region (19a, 19b, 19c) the two or more echo acquisitions of the sequence are assigned to different k-space segments (20), whose intersection points lie in the respective radial region (19a, 19b, 19c) depending on the direction of the vector from the first point to the respective second point.

9. Computer-implemented method according to one of the preceding claims, wherein the at least two acquisition parameters comprise an echo time of the respective echo acquisition and/or a flip angle associated to the respective echo acquisition and/or a repetition time (TRa, TRb, TRc, TRd) of the respective data acquisition shot (17a, 17b, 17c, 17d) and/or an inversion time of the respective data acquisition shot (17a, 17b, 17c, 17d) and/or a dead time (TDa, TDb, TDc, TDd) of the respective data acquisition shot (17a, 17b, 17c, 17d).

10. Computer-implemented method according to one of the preceding claims, wherein the sequence of echo acquisitions is a non-repetitive sequence.

11. Computer-implemented method according to one of the preceding claims, wherein the plurality of data acquisition shots (17a, 17b, 17c, 17d) comprises at least two subsequent data acquisition shots (17a, 17b, 17c, 17d) with different repetition times (TRa, TRb, TRc, TRd).

12. Method for controlling an MRI system (1), wherein
- a computer-implemented method according to one of the preceding claims is carried out;
- the MRI system (1) is controlled to carry out the MRI data acquisition, wherein for each echo acquisition of the sequence, a respective k-space segment (20), which is assigned to the respective each echo acquisition of the sequence according to the k-space ordering scheme (S), is sampled.

13. Data processing system (16), which is configured to carry out a computer-implemented method according to one of claims 1 to 11.

14. MRI system (1) comprising a data processing system (16) according to claim 13 and a controller (15), which is configured to control the MRI system (1) to carry out the MRI data acquisition, wherein for each echo acquisition of the sequence, a respective k-space segment (20), which is assigned to the respective each echo acquisition of the sequence according to the k-space ordering scheme (S), is sampled.

15. Computer program product comprising
- first instructions, which, when executed by a data processing system (16), cause the data processing system (16) to carry out a computer-implemented method according to one of claims 1 to 11; and/or
- second instructions, which, when executed by an MRI system (1) according to claim 14, cause the MRI system (1) to carry out a method according to claim 12.
